(19)

Europäisches Patentamt

European Patent Office

Office européen des brevets

(11) **EP 2 637 312 B1**

(12) **EUROPEAN PATENT SPECIFICATION**

(45) Date of publication and mention of the grant of the patent:
**11.01.2017 Bulletin 2017/02**

(51) Int Cl.:
*H03D 1/22* (2006.01)   *H04B 1/30* (2006.01)
*H04L 25/06* (2006.01)

(21) Application number: **12158600.2**

(22) Date of filing: **08.03.2012**

(54) **ALGORITHM FOR FINE RF TRANSCEIVER DC OFFSET CALIBRATION**

ALGORITHMUS MIT HF-SENDER-EMPFÄNGER GLEICHSTROM-OFFSET-KALIBRIERUNG

ALGORITHME POUR L'ÉTALONNAGE FIN DU DÉCALAGE CC D'UN ÉMETTEUR-RÉCEPTEUR RF

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**11.09.2013 Bulletin 2013/37**

(73) Proprietor: **Intel Deutschland GmbH**
**85579 Neubiberg (DE)**

(72) Inventors:
• **Müller, Peter**
  **01279 Dresden (DE)**

• **Nitsche, Gunnar**
  **01445 Radebeul (DE)**

(74) Representative: **Lippert, Stachow & Partner**
**Patentanwälte**
**Krenkelstrasse 3**
**01309 Dresden (DE)**

(56) References cited:
**US-A1- 2002 094 792    US-A1- 2006 222 117**
**US-A1- 2006 284 671    US-A1- 2007 153 945**
**US-A1- 2007 184 803    US-B1- 7 239 199**

**Description**

Technical Field

The present invention relates to a method for compensating DC offset in RF transceivers. The present invention specifically relates to a method for performing gain independent DC offset compensation.

Prior Art

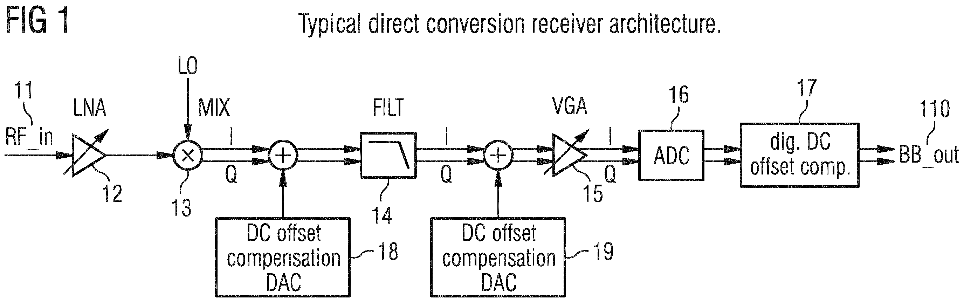

Integrated direct conversion RF transceiver architectures became popular in the last decade for many different RF applications. They require a minimal set of building blocks, see Fig. 1. Each RX or TX signal path requires only one mixer with associated local oscillator which also simplifies the synthesizer. An IF filter is no longer needed.

But this architecture has also drawbacks. DC offset is introduced by the individual transceiver/receiver components like amplifier, mixer, filter etc. It may distort the signal, and directly limits the available dynamic range. Strong offsets can saturate the signal path and also violate the digital signal processing. It became common to compensate this DC offset by adding DC voltages opposite to the occurring DC offset. Several different solutions have been developed in the past.

One typical approach is providing additional hardware blocks as disclosed in US 6,756,924 B2 or US 7,271,649 B2 or Tanaka, T. Yamawaki, K. Takikawa, N. Hayashi, I. Ohno, T.Wakuta, S. Takahashi, M. Kasahara, and B. Henshaw, "GSM/DCS1800 Dual Band Direct-Conversion Transceiver IC With a DC Offset Calibration System," in 01 ESSCIRC Session 3.3, 2001. These blocks are typically dedicated to individual building blocks. The DC offset is measured and compensated. This approach requires additional elements not only for compensation, e.g. DACs, but also for measuring the DC offset and for determining the value needed for compensation. These blocks are running permanently. They increase the system complexity and consume additional power and space.

Other approaches determine the DC offset and the resulting DC compensation values permanently in the digital domain as disclosed in Marko Mailand and Hans-Joachim Jentschel, "Compensation of DC-Offsets and RF-Self-Mixing Products in Six-Port-Based Analog Direct Receivers," in 14th IST Mobile & Wireless Communication Summit, Dresden, June 2005; or Russell Hoppenstein, "DC Offset Auto-Calibration of TRF371x," Texas Instruments, 2010; or I.-H. Sohn, E.-R. Jeong, and Y. H. Lee, "Data-Aided Approach to I/Q Mismatch and DC Offset Compensation in Communication Receivers," IEEE COMMUNICATIONS LETTERS, vol. 6, no. 12, December 2002. The compensation values are introduced by a DAC in the analog section. But this concept prepares only one set of compensation values. This is working well if the system gain is fixed. But systems with variable gain make the DC offset variably as well. Therefore every new gain configuration requires new DC offset values to be measured and new compensation values to be set. This increases the steps to be done to change the gain as additional calibration steps must be executed as well for every new gain setting. Setting the gain becomes more complex and time consuming.

Fig. 1 shows a state-of-the art direct conversion receiver comprising a plurality of components like low noise amplifier 12, mixer 13, filter 14, VGA 15, ADC 16, digital DC offset compensation 17 between radio frequency (RF) input 11 and baseband (BB) output. Direct conversion RF transceivers, e.g. for WLAN, did use more than one point to enter DC compensation voltages by additional DACs 18, 19. These DC compensation voltages (the calibration parameters) were typically determined from different measurements and from calculations in the digital domain, e.g. by a signal processor. It is common to add short cut and bypass switches to the individual transceiver/receiver components to measure the DC offset that occurs at each individual stage separately. Therefore, some of the components were operated under debug/test conditions (bypass or short cut mode) instead of the real operation conditions while the DC offset is measured. This introduces additional errors, e.g. due to different bias or temperature conditions, and increases the system complexity.

It is generally intended to find a set of calibration parameters that covers the complete gain control range. But this is not common in present implementations as the accuracy of the determined calibration parameters is insufficient. Therefore, the complete gain control range is split into several different sub ranges. Each different sub range has an own set of set of calibration parameters. Changing the gain from one sub range to another requires also the calibration parameters to be changed which is still complex and time consuming. US 2007/0184803 A1 a calibration is performed by sequentially calibrating each variable amplifier in an amplifier chain.

The transceiver (Rx path) with DC offset sources and compensation DACs (digital to analog converters) given in Fig. 1, can be simplified, see Fig.2, to a set of variable gain stages 23 corresponding to mixer 13, 24 corresponding to filter 14, 25 corresponding to VGA 15 between RF input 21 and BB output 210, where the DC offset 211, 212, 213 and the compensation DACs 28 and 29 are connected to the input of each individual stage. The mathematical expression of this simplified model is given in Fig.3 comprising a plurality of gain stages 321,...,32k,...,32n, DC offsets 330,331,...,33k...33n and compensation DACs 320,321,...,32k,...,32n between RF input 31 and BB output 35.

The compensation DACs are connected to the signal path, Fig.1. Each DAC adds a DC voltage that is opposite to the DC offset at this point so that the total DC becomes close to zero. This remaining voltage nonzero DC voltage becomes amplified by the gain stages that follow. As this gain is variable the resulting DC offset at the output of said signal path directly depends on the following total gain and the DC offset residual:

$$mean(BB_{out}) = \sum_{k=1}^{n} \left[ A_{tot,k} \times \left[ DC_{off,k} + DC_{comp,k} \right] \right]$$

The total gain for the gain stage k (k>0) is given by:

$$A_{tot,k} = \prod_{j=1}^{k} A_{j,i}$$

Therefore, a good calibration algorithm should find values $DC_{comp,k}$ that meet the relation:

$$0 \approx DC_{off,k} + DC_{comp,k}$$

The essential part of the calibration routines is therefore to determine $DC_{off,k}$ accurately from different measured mean ($BB_{out}$) values so that

$$DC_{comp,k} = -DC_{off,k}$$

Throughout this document the following notation will be used:

| | |
|---|---|
| number of total gain stages: | n |
| DC offset of gain stage k: | $DC_{off,k}$ |
| DC compensation parameter of gain stage k: | $DC_{comp,k}$ |
| DC offset residual of gain stage k: | $DC_{off,k}+DC_{comp,k}$ |
| gain control range R of gain stage k: | $A_{k,R}$ |
| gain i of stage k, were $A_{k,i}$ element of $A_{k,R}$: | $A_{k,i}$ |
| total gain for gain stage k: | $A_{tot,k}$ |
| DC offset residual at ADC ouput (BB_out): | $DC_{res}$ |

Disclosure of the Invention

It is therefore an objective of the present invention to provide a method for compensating DC offset in radio frequency transceiver architectures having an improved efficiency. It is specifically an objective of the present invention to provide an improved DC offset calibration method for RF transceivers with variable gain that provide multiple points with compensation DACs (digital to analog converters) for DC offset compensation.

This objective is achieved by a method according to the independent claim. Dependent claims relate to further aspects of the present invention.

The present invention relates to a method for compensating DC offset in a signal path comprising a plurality of stages, each stage k having an individual gain $A_k$ and a total gain $A_{tot,k}$ that is the product of the gains of all preceding stages and the gain of said stage: $A_{tot,k}=A_k*A_{tot,k-1}$.

For each stage a DC calibration is performed by introducing a DC compensation signal $DC_{comp,k}$ into the signal path of said stage by means of an compensation analog to digital converter that is electrically coupled to said stage and that is configured to add the DC compensation signal to the DC offset of said stage.

The procedure is based on finding intersection points were the intersection points found represent the best compensation values. At least two lines, e.g. four points are required for obtaining one DC compensation signal. One line represents a set of different compensation DAC values for the dedicated gain of the stage behind the compensation DAC. Measurement values for at least two gain configurations are mandatory. More gains are possible. More measurement points for one gain configuration may help to increase the accuracy and eliminate nonlinearities of the compensation DACs.

A DC compensation signal is determined by

setting the total gain of said stage to a value that equals the product of a first total gain of the preceding stage(s) and a first gain of said stage by setting a first gain of each of the preceding stage(s) and a first gain of said stage,

setting at least two different DC compensation signals for said stage and measuring a DC residual signal at the output of the signal path for each of the two different DC compensation signals in order to determine a first linear relationship between DC compensation signal and DC offset residual at the output of said signal path,

setting the total gain of said stage to a value that equals the product of a second total gain of the preceding stage(s) and a second gain of said stage by setting a second gain of each of the preceding stage(s) and a second gain of said stage,

setting at least two different DC compensation signals and measuring a DC residual signal at the output of the signal path for each of the two different DC compensation signals in order to determine a second linear relationship between DC compensation value and gain, and

determining an interception point of said first linear relationship and said second linear relationship, wherein the DC compensation signal of said interception point is the DC compensation signal.

The DC compensation may be performed stage by stage starting with the stage that is closest to the input of said signal path, i.e. closest to RF input, k=n.

The DC compensation may be performed stage by stage starting with the stage that is closest to the output of said signal path. Here, several iterations are required.

One aspect of the DC calibration relates to the setting of the total gain of the preceding stages. The first and/or the second total gain of the preceding stages are preferably set to the mean total gain of the preceding stages. This implies setting the first and/or second gain of each of the preceding stages to its mean gain. Therefore, the total gain of the preceding gain stages are constant and approximately in the middle of the used control range.

One aspect of the DC calibration relates to the setting of the gain of said stage. The first gain of said stage is preferably set to the minimum gain of said stage. The second gain of said stage is preferably set to the maximum gain of said stage.

The calibration coefficients obtained by the DC compensation keep the gain dependency of the DC offset residuum small.

One aspect of the present invention relates to performing a raw DC calibration prior to the DC calibration. The raw DC calibration increases the stability of the calibration process so that the entire calibration procedure works for huge DC offsets. Raw DC calibration can be hardware supported and comprise any method referred to in the prior art section. Raw DC calibration methods have a broader error tolerance range compared to fine DC calibration methods. Usually raw DC calibration methods also converge faster.

For each stage a raw DC calibration may be performed by introducing a raw DC compensation signal $DC_{comp,k}$ into said stage by means of an compensation digital to analog converter that is electrically coupled to said stage and that is configured to add the DC compensation signal to the DC offset of said stage.

The raw DC compensation is performed stage by stage starting with the stage that is closest to the output of said signal path. Said raw DC compensation signal for said stage is determined by :

measuring a DC offset residual at the output of said signal path,
setting the raw DC compensation signal to a value that is the negative of the DC offset residual divided by the total gain of said stage, wherein the total gain of said stage is the product of the gains of all preceding stages and the gain of said stage ..

The DC compensation signal of gain stage k, $DC_{comp,k}$ can be calculated from the known total gain $A_{tot,k}$ and the measured DC offset residual $DC_{res}$ by the formula:

$$DC_{comp,k,m} = DC_{comp,k,m-1} - \frac{DC_{RES,m}}{A_{tot,k}}$$

where $DC_{comp,k,m}=0$.

The DC calibration is performed iteratively by determining the DC compensation signals for m calibration iterations for each stage, wherein m is positive integer.

One aspect of the raw DC calibration relates to the selection of the total gain $A_{tot,k}$ of each gain stage. It is preferably selected to be approximately in the middle between its minimum and maximum:

$$A_{tot,k} \approx \frac{A_{tot,k,max} - A_{tot,k,min}}{2}$$

As the total gain of a stage is dependent on the gain of said stage and the gains of all preceding stages, this implies setting the individual gain of each stage to an arithmetic mean of a maximum individual gain of said stage and a minimum individual gain of said stage.

The computed calibration coefficients obtained by the raw DC calibration are good enough to prevent the system from saturation while the DC calibration is performed.

Therefore, the present invention provides a method for determining a set of calibration parameters $DC_{comp,k}$ having the advantage of covering the complete gain control range from $A_{tot,n,min}$ to $A_{tot,n,max}$ so that changing the gain does not require any additional calibration tasks or calibration parameter changes.

It is another advantage of the present invention that the transceiver operates close to regular operation mode during calibration. Thus, unwanted measurement errors due to different device states, e.g. different bias and temperature conditions are avoided. Only loop back functionality might be needed. Power down or feed trough operation is not required.

It is yet another advantage of the present invention that only DC offset compensation elements, e.g. DACs that are common in present RF transceivers are required.

Brief Description of the Drawings

The method and the device according to the invention are described in more detail herein below by way of exemplary embodiments and with reference to the attached drawings, in which:

Fig. 1 shows a state-of-the-art direct conversion receiver architecture,

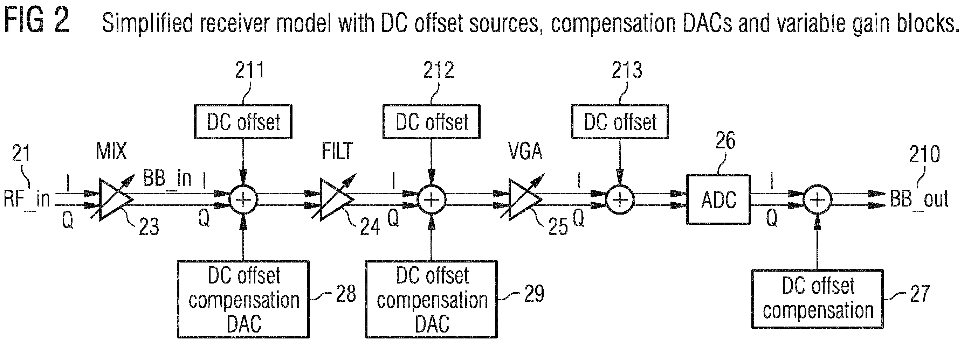

Fig.2 shows a simplified receiver model,

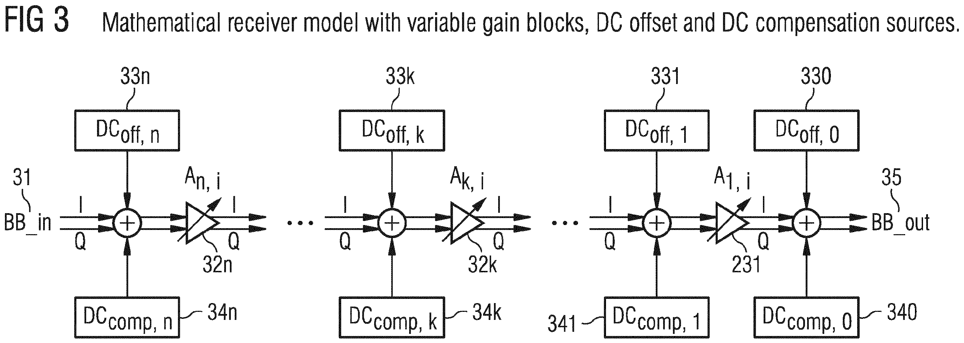

Fig.3 shows mathematical receiver model,

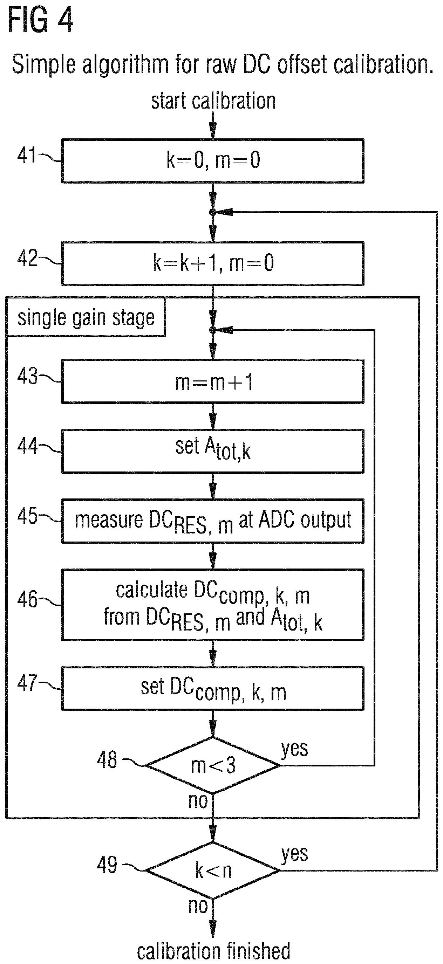

Fig.4 shows flow chart of a raw DC offset calibration algorithm,

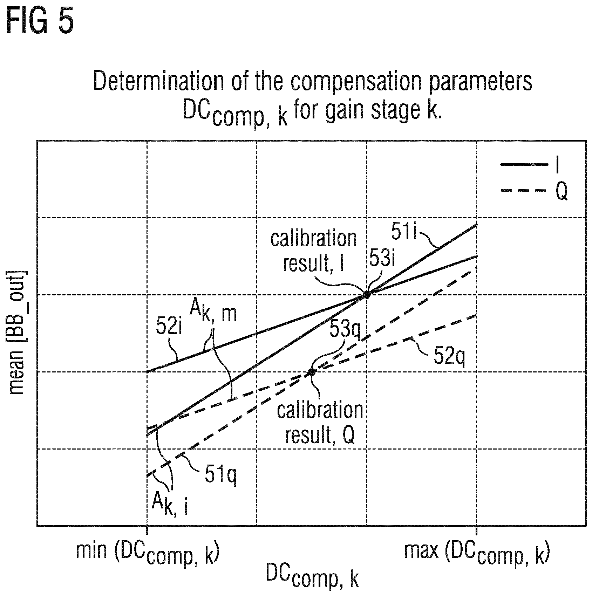

Fig.5 shows diagram of functional relationships between DC offset compensation parameters and DC offset residuals, and

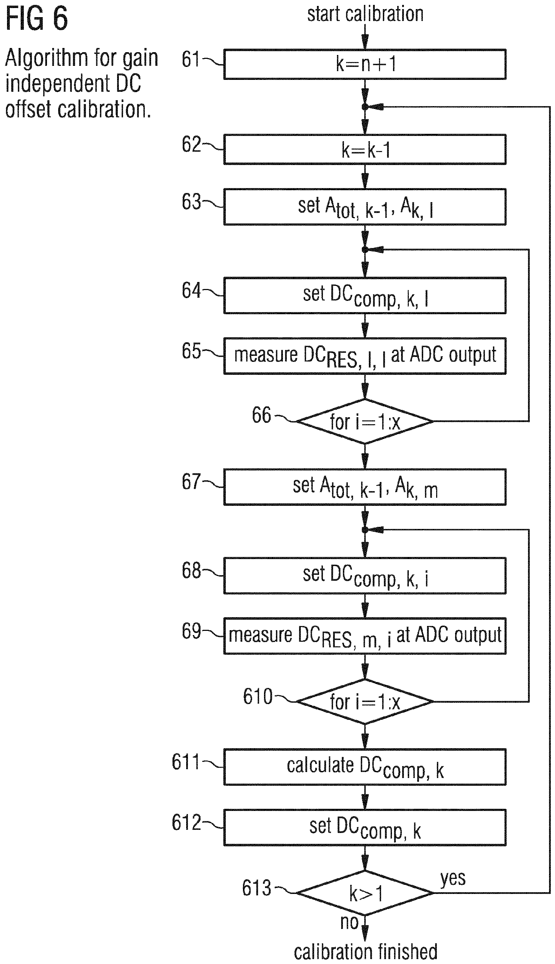

Fig.6 shows a flow chart of an algorithm for gain independent offset calibration.

Embodiments of the Invention

Fig. 5 shows a diagram of a functional relationship of a DC compensation signal and DC residual for one specific embodiment of the DC calibration procedure, wherein for each of the channels I and Q a calibration result is obtained by determining the first linear relationship for I 51i and Q 52q and the second linear relationship for I 52i and Q 52q and intersecting them in order to find the optimal DC compensation signal for I 53i and Q 53q.

Fig. 6 shows a flow chart of an embodiment of the DC calibration algorithm. In step 61 the stage index k is set to n+1, wherein n is the number of stages. The loop for a single stage comprises the steps 62 to 612, wherein the loop is left in step 613 in case all stages have been computed. In the following step 62 the stage index k is decremented by 1. Therefore, the following steps that relate to a single gain stage start with stage k=n, which is the stage closest to RF input. The total gain of the preceding stages $A_{tot,k-1}$ and the first gain $A_{k,l}$ of stage k is set in step 63. The first gain $A_{k,l}$ set to the minimum of $A_k$. In the first inner loop having loop index i and comprising the steps 64 and 65 the first linear relationship is determined for gain $A_{k,l}$. At least two points are needed, but up to x points may be computed, step 66. In step 64 the DC compensation signal $DC_{comp,k,l}$ is set. In step 65 the DC offset residual $DC_{RES,l,i}$ is measured at the output of the signal path. In the first inner loop the first DC compensation signal is set to its maximum and the second DC compensation signal is set to its minimum. Further DC compensation signals may be set somewhere in between. In step 67 the total gain of the preceding stages $A_{tot,k-1}$ and the second gain $_{Ak,m}$ of stage k is set. The second gain $A_{k,m}$ is set to its maximum value. In the second inner loop having loop index i and comprising the steps 68 and 69 the second linear relationship is determined for gain $A_{k,m}$. At least two points are needed, but up to x points may be computed, step 66. In step 64 the DC compensation signal $DC_{comp,k,i}$ is set. In step 65 the DC offset residual $DC_{RES,l,i}$ is measured at the output of the signal path. In the first inner loop the first DC compensation signal is set to its maximum and the second DC compensation signal is set to its minimum. Further DC compensation signals may be set somewhere in between. In step 611 the DC compensation signal $DC_{comp,k}$ for stage k is computed. In step 612 the DC compensation signal $DC_{comp,k}$ is set.

Fig. 4 shows a flow chart of an embodiment of a raw DC compensation algorithm that is executed before the DC compensation is performed. In step 41 the algorithm is initialized by setting the stage index and the calibration iteration index to zero. The outer loop comprising steps 42 to 49 refers to the computation of raw DC offset compensation signals for all stages. In step 42 the stage index k is incremented by one. In step 49 the outer loop is left in case all stages have been computed. The inner loop comprising steps 43 to 48 refers to the computation of raw DC compensation signals for a single stage k. In step 43 the calibration index m is incremented by one. In step 44 the gain of stage k is set. In step 45 the resulting DC offset residual DCRES,m is measured. In step 46 the DC compensation signal DCcomp,k,m is computed. In step 47 the DC compensation signal DCcomp,k,m is set. The inner loop is executed three times according to step 48.

**Claims**

1. Method for compensating DC offset in a signal path comprising a plurality of stages (k, n) arranged in a chain forming a signal path, each stage having an individual gain wherein for each stage (k, n) a DC compensation is performed by introducing a DC compensation signal (340...34k...34n) into said stage by means of a compensation digital to analog converter that is configured to add the DC compensation signal to the DC offset of said stage (k, n), wherein said DC compensation signal is determined by
setting a first gain of each of the preceding stage(s) and a first gain of said stage,
setting at least two different DC compensation signals for said stage and
measuring a DC residual signal at the output (35) of the signal path for each of the two different DC compensation signals in order to determine a first linear relationship (51i, 51q) between DC compensation signal and DC offset residual at the output (35) of said signal path,
setting a second gain of each the preceding stage(s) and a second gain of said stage,
setting at least two different DC compensation signals and
measuring a DC residual signal at the output (35) of the signal path for each of the two different DC compensation signals in order to determine a second linear relationship (52i, 52q) between DC compensation value and gain,
**characterised by**
determining an interception point (53i, 53q) of said first linear relationship and said second linear relationship, wherein the DC compensation signal of said interception point is the DC compensation signal of the compensation digital to analog converter of said stage.

2. Method according to claim 1, wherein the fine DC compensation is performed stage (k, n) by stage (k, n) starting with the stage that is closest to the input (31) of said signal path.

3. Method according to claim 1, wherein the fine DC compensation is performed stage (k, n) by stage (k, n) starting with the stage that is closest to the output (35) of said signal path.

4. Method according to any of claims 1 to 3, wherein the first gain of each of the preceding stage(s) is the mean gain of the preceding stage(s).

5. Method according to any of claims 1 or 4, wherein the second gain of each of the preceding stage(s) is the mean total gain of the preceding stages.

6. Method according to any of claims 1 to 5, wherein the first gain of said stage (k, n) is the minimum gain of said stage (k, n).

7. Method according to any of claims 1 to 6, wherein the second gain of said stage (k, n) is the maximum gain of said stage (k, n).

8. Method according to any of claims 1 to 7, wherein one of said different DC compensation signals is a minimum DC compensation signal and/or one of said different compensation signals is a maximum DC compensation signal.

9. Method according to any of claims 1 to 8 wherein prior to the DC compensation a raw DC compensation is performed.

10. Method according to claim 9, wherein for each stage the raw DC compensation is performed by introducing a raw DC compensation signal stage by means of the compensation digital to analog converter of said stage;

wherein the raw DC compensation is performed stage by stage starting with the stage that is closest to the output of said signal path;
wherein said raw DC compensation signal for said stage is determined by:

measuring a DC offset residual at the output (35) of said signal path,
setting the DC compensation signal to a value that is the negative of the DC offset residual divided by a total gain of said stage, wherein the total gain of said stage is the product of the individual gains of all preceding stages and the gain of said stage; and
repeating the measuring of the DC offset residual and the setting the DC compensation signal.

11. Method according to claim 10, the method further comprising:

setting the individual gain of each stage to an arithmetic mean of a maximum individual gain of said stage and a minimum individual gain of the stage so that the total gain of said stage is an arithmetic mean of a maximum total gain of said stage and a minimum total gain of said stage.

**Patentansprüche**

1. Verfahren zum Kompensieren des Gleichstromversatzes in einem Signalweg, der mehrere Stufen (k, n) umfasst, die in einer Kette angeordnet sind, die einen Signalweg bildet, wobei jede Stufe eine individuelle Verstärkung aufweist, wobei für jede Stufe (k, n) durch Einbringen eines Gleichstromkompensationssignals (340,..., 34k,..., 34n) in die Stufe mittels eines Kompensations-Digital/Analog-Umsetzers, der konfiguriert ist, das Gleichstromkompensationssignal zum Gleichstromversatz der Stufe (k, n) zu addieren, eine Gleichstromkompensation durchgeführt wird, wobei das Gleichstromkompensationssignal bestimmt wird durch
Einstellen einer ersten Verstärkung jeder der vorhergehenden Stufe(n) und einer ersten Verstärkung der Stufe,
Einstellen mindestens zweier verschiedener Gleichstromkompensationssignale für die Stufe und
Messen eines Gleichstromrestsignals am Ausgang (35) des Signalwegs für jedes der zwei verschiedenen Gleichstromkompensationssignale, um eine erste lineare Beziehung (51i, 51q) zwischen dem Gleichstromkompensationssignal und dem Gleichstromversatzrestwert am Ausgang (35) des Signalwegs zu bestimmen,
Einstellen einer zweiten Verstärkung jeder der vorhergehenden Stufe(n) und einer zweiten Verstärkung der Stufe,
Eistellen mindestens zweier verschiedener Gleichstromkompensationssignale und
Messen eines Gleichstromrestsignals am Ausgang (35) des Signalwegs für jedes der zwei verschiedenen Gleichstromkompensationssignale, um eine zweite lineare Beziehung (52i, 52q) zwischen dem Gleichstromkompensationswert und der Verstärkung zu bestimmen, **gekennzeichnet durch**
Bestimmen eines Kreuzungspunktes (53i, 53q) der ersten linearen Beziehung und der zweiten linearen Beziehung, wobei das Gleichstromkompensationssignal des Kreuzungspunkts das Gleichstromkompensationssignal des Kompensations-Digital/Analog-Umsetzers der Stufe ist.

2. Verfahren nach Anspruch 1, wobei die Gleichstromfeinkompensation beginnend mit der Stufe, die sich am nächsten am Eingang (31) des Signalwegs befindet, Stufe (k, n) für Stufe (k, n) durchgeführt wird.

3. Verfahren nach Anspruch 1, wobei die Gleichstromfeinkompensation beginnend mit der Stufe, die sich am nächsten am Ausgang (35) des Signalwegs befindet, Stufe (k, n) für Stufe (k, n) durchgeführt wird.

4. Verfahren nach einem der Ansprüche 1 bis 3, wobei die erste Verstärkung jeder der vorhergehenden Stufe(n) die gemittelte Verstärkung der vorhergehenden Stufe(n) ist.

5. Verfahren nach einem der Ansprüche 1 oder 4, wobei die zweite Verstärkung jeder der vorhergehenden Stufe(n) die gemittelte Gesamtverstärkung der vorhergehenden Stufen ist.

6. Verfahren nach einem der Ansprüche 1 bis 5, wobei die erste Verstärkung der Stufe (k, n) die minimale Verstärkung der Stufe (k, n) ist.

7. Verfahren nach einem der Ansprüche 1 bis 6, wobei die zweite Verstärkung der Stufe (k, n) die maximale Verstärkung der Stufe (k, n) ist.

**8.** Verfahren nach einem der Ansprüche 1 bis 7, wobei eines der verschiedenen Gleichstromkompensationssignale ein minimales Gleichstromkompensationssignal ist und/oder eines der verschiedenen Kompensationssignale ein maximales Gleichstromkompensationssignal ist.

**9.** Verfahren nach einem der Ansprüche 1 bis 8, wobei vor der Gleichstromkompensation eine Gleichstromgrobkompensation durchgeführt wird.

**10.** Verfahren nach Anspruch 9, wobei die Gleichstromgrobkompensation für jede Stufe durch Einbringen einer Gleichstromgrobkompensationssignalstufe mittels des Kompensations-Digital/Analog-Umsetzers der Stufe durchgeführt wird;
wobei die Gleichstromgrobkompensation beginnend mit der Stufe, die sich am nächsten am Ausgang des Signalwegs befindet, Stufe für Stufe durchgeführt wird;
wobei das Gleichstromgrobkompensationssignal für die Stufe bestimmt wird durch:

Messen eines Gleichstromversatzrestwerts am Ausgang (35) des Signalwegs,
Einstellen des Gleichstromkompensationssignals auf einen Wert, der der negative Wert des Gleichstromversatzrestwerts geteilt durch eine Gesamtverstärkung der Stufe ist, wobei die Gesamtverstärkung der Stufe das Produkt der individuellen Verstärkungen aller vorhergehender Stufen und der Verstärkung der Stufe ist; und
Wiederholen des Messens des Gleichstromversatzrestwerts und des Einstellens des Gleichstromkompensationssignals.

**11.** Verfahren nach Anspruch 10, wobei das Verfahren ferner umfasst:

Einstellen der individuellen Verstärkung jeder Stufe auf ein arithmetisches Mittel einer maximalen, individuellen Verstärkung der Stufe und einer minimalen, individuellen Verstärkung der Stufe, derart, dass die Gesamtverstärkung der Stufe ein arithmetisches Mittel einer maximalen Gesamtverstärkung der Stufe und einer minimalen Gesamtverstärkung der Stufe ist.

**Revendications**

**1.** Procédé de compensation d'un décalage de courant continu dans un trajet de signal comprenant une pluralité d'étages (k, n) agencés en une chaîne formant un trajet de signal, chaque étage ayant un gain individuel dans lequel, pour chaque étage (k, n), une compensation de courant continu est réalisée en introduisant un signal de compensation de courant continu (340 ... 34k ... 34n) dans ledit étage au moyen d'un convertisseur analogique-numérique de compensation qui est configuré pour ajouter le signal de compensation de courant continu au décalage de courant continu dudit étage (k, n), dans lequel ledit signal de compensation de courant continu est déterminé en réglant un premier gain de chacun du ou des étage(s) précédent(s) et un premier gain dudit étage,
réglant au moins deux signaux de compensation de courant continu différents pour ledit étage, et en mesurant un signal résiduel de courant continu à la sortie (35) du trajet de signal pour chacun des deux signaux de compensation de courant continu différents afin de déterminer une première relation linéaire (51i, 51q) entre le signal de compensation de courant continu et le décalage de courant continu résiduel à la sortie (35) dudit trajet de signal,
réglant un second gain de chacun du ou des étage(s) précédent(s) et un second gain dudit étage,
réglant au moins deux signaux de compensation de courant continu différents et en mesurant un signal résiduel de courant continu à la sortie (35) du trajet de signal pour chacun des deux signaux de compensation de courant continu différents afin de déterminer une seconde relation linéaire (52i, 52q) entre une valeur de compensation de courant continu et un gain, **caractérisé par**
déterminer un point d'interception (53i, 53q) de ladite première relation linéaire et de ladite seconde relation linéaire, dans lequel le signal de compensation de courant continu dudit point d'interception est le signal de compensation de courant continu du convertisseur analogique-numérique de compensation dudit étage.

**2.** Procédé selon la revendication 1, dans lequel la compensation de courant continu fine est effectuée étage (k, n) par étage (k, n), en commençant par l'étage qui est le plus proche de l'entrée (31) dudit trajet de signal.

**3.** Procédé selon la revendication 1, dans lequel la compensation de courant continu fine est effectuée étage (k, n) par étage (k, n), en commençant par l'étage qui est le plus proche de la sortie (35) dudit trajet de signal.

4. Procédé selon l'une quelconque des revendications 1 à 3, dans lequel le premier gain de chacun du ou des étage(s) précédent(s) est le gain moyen du ou des étage(s) précédent(s).

5. Procédé selon l'une quelconque des revendications 1 ou 4, dans lequel le second gain de chacun du ou des étage(s) précédent(s) est le gain total moyen des étages précédents.

6. Procédé selon l'une quelconque des revendications 1 à 5, dans lequel le premier gain dudit étage (k, n) est le gain minimal dudit étage (k, n).

7. Procédé selon l'une quelconque des revendications 1 à 6, dans lequel le second gain dudit étage (k, n) est le gain maximal dudit étage (k, n).

8. Procédé selon l'une quelconque des revendications 1 à 7, dans lequel l'un desdits signaux de compensation de courant continu différents est un signal de compensation de courant continu minimal et/ou l'un desdits signaux de compensation différents est un signal de compensation de courant continu maximal.

9. Procédé selon l'une quelconque des revendications 1 à 8, dans lequel, avant la compensation de courant continu, une compensation de courant continu brute est effectuée.

10. Procédé selon la revendication 9, dans lequel pour chaque étage, la compensation de courant continu brute est effectuée en introduisant un étage de signal de compensation de courant continu brute au moyen du convertisseur analogique-numérique de compensation dudit étage ;

dans lequel la compensation de courant continu brute est effectuée étage par étage en commençant par l'étage qui est le plus proche de la sortie dudit trajet de signal ;

dans lequel ledit signal de compensation de courant continu brute pour ledit étage est déterminé en :

mesurant un décalage de courant continu résiduel à la sortie (35) dudit trajet de signal,

réglant le signal de compensation de courant continu à une valeur qui est le négatif du décalage de courant continu résiduel divisé par un gain total dudit étage, dans lequel le gain total dudit étage est le produit des gains individuels de tous les étages précédents et du gain dudit étage ; et en

répétant la mesure du décalage de courant continu résiduel et le réglage du signal de compensation de courant continu.

11. Procédé selon la revendication 10, le procédé comprenant en outre de :

régler le gain individuel de chaque étage à une moyenne arithmétique d'un gain individuel maximal dudit étage et un gain minimal individuel de l'étage de telle sorte que le gain total dudit étage est une moyenne arithmétique d'un gain total maximal dudit étage et d'un gain total minimal dudit étage.

FIG 1                    Typical direct conversion receiver architecture.

FIG 2    Simplified receiver model with DC offset sources, compensation DACs and variable gain blocks.

EP 2 637 312 B1

FIG 3    Mathematical receiver model with variable gain blocks, DC offset and DC compensation sources.

EP 2 637 312 B1

# FIG 4

Simple algorithm for raw DC offset calibration.

start calibration

41 — $k=0, m=0$

42 — $k=k+1, m=0$

**single gain stage**

43 — $m=m+1$

44 — set $A_{tot,k}$

45 — measure $DC_{RES, m}$ at ADC output

46 — calculate $DC_{comp, k, m}$ from $DC_{RES, m}$ and $A_{tot, k}$

47 — set $DC_{comp, k, m}$

48 — $m<3$  yes / no

49 — $k<n$  yes / no

calibration finished

# FIG 5

Determination of the compensation parameters
$DC_{comp,\,k}$ for gain stage k.

# FIG 6

Algorithm for gain
independent DC
offset calibration.

start calibration

61 — $k = n+1$

62 — $k = k-1$

63 — set $A_{tot,\,k-1}$, $A_{k,\,l}$

64 — set $DC_{comp,\,k,\,l}$

65 — measure $DC_{RES,\,l,\,l}$ at ADC output

66 — for $i = 1{:}x$

67 — set $A_{tot,\,k-1}$, $A_{k,\,m}$

68 — set $DC_{comp,\,k,\,i}$

69 — measure $DC_{RES,\,m,\,i}$ at ADC output

610 — for $i = 1{:}x$

611 — calculate $DC_{comp,\,k}$

612 — set $DC_{comp,\,k}$

613 — $k > 1$    yes

no

calibration finished

**EP 2 637 312 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6756924 B2
- US 7271649 B2
- US 20070184803 A1

### Non-patent literature cited in the description

- **TANAKA, T. YAMAWAK ; K. TAKIKAWA ; N. HAYASHI ; I. OHNO ; T.WAKUTA ; S. TAKAHASHI ; M. KASAHARA ; B. HENSHAW.** GSM/DCS1800 Dual Band Direct-Conversion Transceiver IC With a DC Offset Calibration System. *01 ESSCIRC,* 03 March 2001
- **MARKO MAILAND ; HANS-JOACHIM JENTSCHEL.** Compensation of DC-Offsets and RF-Self-Mixing Products in Six-Port-Based Analog Direct Receivers. *14th IST Mobile & Wireless Communication Summit, Dresden,* June 2005
- **RUSSELL HOPPENSTEIN.** *DC Offset Auto-Calibration of TRF371x,* 2010
- **I.-H. SOHN ; E.-R. JEONG ; Y. H. LEE.** Data-Aided Approach to I/Q Mismatch and DC Offset Compensation in Communication Receivers. *IEEE COMMUNICATIONS LETTERS,* December 2002, vol. 6 (12